Europäisches Patentamt

European Patent Office

Office européen des brevets

(19)

(11) **EP 0 714 171 B1**

(12) **EUROPÄISCHE PATENTSCHRIFT**

(45) Veröffentlichungstag und Bekanntmachung des Hinweises auf die Patenterteilung:
**16.05.2001 Patentblatt 2001/20**

(51) Int Cl.7: **H03M 1/24**

(21) Anmeldenummer: **95118192.4**

(22) Anmeldetag: **18.11.1995**

(54) **Vorrichtung und Verfahren zur Bestimmung der Position eines Körpers**

Device and method for determining the position of a body

Dispositif et procédé pour la détermination de la position d'un corps

(84) Benannte Vertragsstaaten:
**AT CH DE FR GB IT LI**

(30) Priorität: **23.11.1994 CH 351994**

(43) Veröffentlichungstag der Anmeldung:
**29.05.1996 Patentblatt 1996/22**

(73) Patentinhaber: **Dr. Johannes Heidenhain GmbH 83292 Traunreut (DE)**

(72) Erfinder: **Toth, Peter CH-8302 Kloten (CH)**

(56) Entgegenhaltungen:
**EP-A- 0 201 106**        **DE-A- 4 120 343**
**US-A- 4 384 275**

**Beschreibung**

Die Erfindung betrifft eine Vorrichtung zur Bestimmung der Position eines Körpers sowie ein Verfahren zur Bestimmung der Position eines Körpers.

Zur Bestimmung der Position eines Körpers sind inkrementale und absolute Meßsysteme bekannt. Bei inkrementalen Meßsystemen wird die Position durch richtungsabhängiges Zählen von Impulsen gewonnen. Der Vorteil eines inkrementalen Meßsystems ist die hohe Auflösung, nachteilig ist dagegen, daß bei Ausfall der Energieversorgung in der Regel eine Referenzposition angefahren werden muß. Bei absoluten Meßsystemen erfolgt die Ermittlung der Position durch Abtastung eines Codes. Der Vorteil besteht darin, daß zu jeder Zeit über den gesamten Meßbereich die absolute Position zur Verfügung steht, nachteilig ist aber die relativ geringe Auflösung.

Man hat nun versucht, die Vorteile des inkrementalen und des absoluten Meßsystems in einem Meßsystem zu vereinigen. Ein derartiges Meßsystem - von dem diese Erfindung ausgeht - ist aus der DE-34 07 102-C2 bekannt. An einer Antriebswelle, deren Winkelposition absolut erfaßt werden soll, ist direkt eine Impulsscheibe befestigt, deren Markierungen von einer ortsfesten Abtasteinheit abgetastet und richtungsabhängig gezählt werden.

Mit der Antriebswelle ist weiterhin über ein Untersetzungsgetriebe eine Codescheibe gekoppelt, die eine Folge von Sektoren absoluter Positionswerte kennzeichnender Codierungen aufweist. Das Übersetzungsverhältnis des Untersetzungsgetriebes ist so gewählt, daß eine vollständige Umdrehung oder ein ganzzahliger Bruchteil einer vollständigen Umdrehung der Antriebswelle zu einer Drehung der Codescheibe um einen Sektor entsprechenden Winkel führt. Die Impulsscheibe weist weitere Markierungen auf, die zur Erzeugung je eines Synchronisierimpulses bei jedem Sektor der Codescheibe dienen. Der absolute Positionswert der Codescheibe wird nur dann in eine Auswerteeinheit übernommen, wenn das Synchronisiersignal von der Impulsscheibe ansteht.

Nachteilig bei diesem bekannten Meßsystem ist die Notwendigkeit eines aufwendigen Übersetzungsgetriebes mit einem relativ hohen Übersetzungsverhältnis. In der DE-34 07 102-C2 sind hierzu komplizierte Umlauf- und Schrittgetriebe angegeben.

Aufgabe der Erfindung ist es, eine Vorrichtung zur Bestimmung der Position eines Körpers anzugeben, die kompakt und robust aufgebaut und flexibel einsetzbar ist.

Diese Aufgabe wird durch die Vorrichtung, mit den Merkmalen des Anspruches 1 gelöst.

Eine weitere Aufgabe der Erfindung ist es, ein Verfahren zur Bestimmung der Position eines Körpers anzugeben, mit dem über einen relativ weiten Meßbereich die Position hochgenau und eindeutig absolut erfaßt werden kann.

Diese Aufgabe wird durch das Verfahren mit den Merkmalen des Anspruches 11 gelöst.

Vorteilhafte Ausbildungen der Erfindung sind in den abhängigen Ansprüchen angegeben.

Die Erfindung wird anhand der Zeichnungen näher erläutert.

Es zeigt:

Figur 1    schematisch eine erste Ausführungsform einer erfindungsgemäßen Winkelmeßvorrichtung,

Figur 2    eine Ausbildung des Codes der Grobcodescheibe der Winkelmeßvorrichtung gemäß Figur 1,

Figur 3    die Anordnung des in Figur 2 dargestellten Codes auf der Grobcodescheibe,

Figur 4    schematisch eine weitere Ausführungsform der Winkelmeßvorrichtung gemäß Figur 1 mit vorgeschaltetem Getriebe,

Figur 5    schematisch eine Winkelmeßeinrichtung mit Übersetzungsgetriebe zwischen Fein- und Grobmeßsystem,

Figur 6    schematisch die Winkelmeßvorrichtung gemäß Figur 1 zur Längenmessung,

Figur 7    ein erstes Beispiel einer Feincodescheibe,

Figur 8    ein zweites Beispiel einer Feincodescheibe,

Figur 9    eine Grobcodescheibe,

Figur 10    eine weitere Grobcodescheibe,

Figur 11    die möglichen Reihenfolgen von Codewerten auf einer Grobcodescheibe und

Figur 12    die möglichen Reihenfolgen von Codewerten auf einer weiteren Grobcodescheibe.

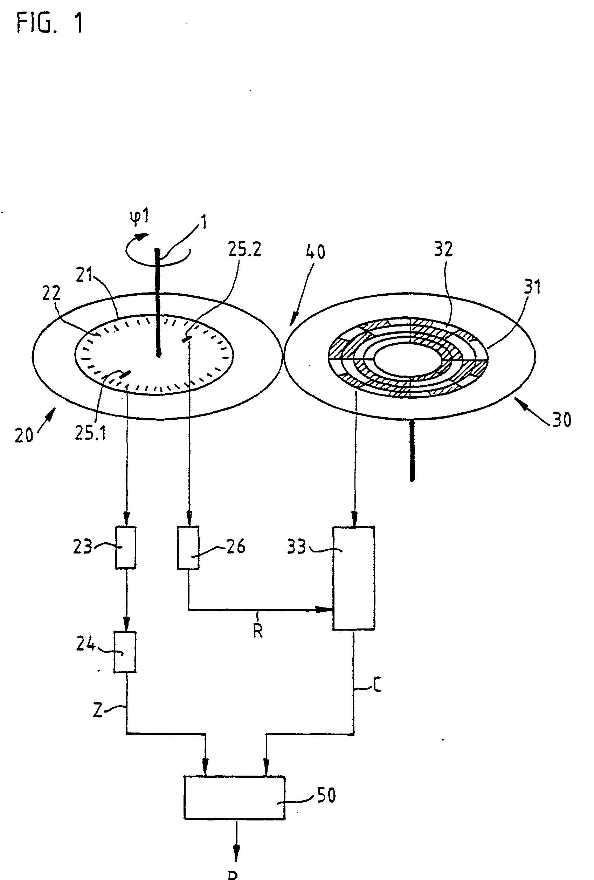

Bei der Winkelmeßvorrichtung gemäß Figur 1 wird der Drehwinkel $\varphi 1$ der Welle 1 über mehrere Umdrehungen absolut gemessen. Hierzu ist ein Feinmeßsystem 20 und ein Grobmeßsystem 30 vorgesehen.

Das Feinmeßsystem 20 besteht aus einer Feincodescheibe 21, die drehfest mit der Welle 1 verbunden ist und somit direkt von der Welle 1 angetrieben wird. Auf der Feincodescheibe 21 ist eine inkrementale Teilung 22 aufgebracht, die in bekannter Weise von einer Abtasteinrichtung 23 lichtelektrisch abgetastet wird und mehrere gegeneinander phasenverschobene Abtastsignale erzeugt werden. Durch Analog-Digital-Wandlung der beispielsweise um 90° gegeneinander phasenverschobenen Abtastsignale werden Impulse erzeugt, die in einem Zähler 24 richtungsabhängig gezählt werden. Im Ausführungsbeispiel besteht die inkrementale Teilung 22 aus 1024 Strichen in gleichmäßiger Verteilung über den Umfang der Feincodescheibe 21. Durch die Analog-Digital-Wandlung zweier um 90° gegeneinander phasenverschobener Abtastsignale werden aus den 1024 Strichen 4096 Zählimpulse generiert.

Auf der Feincodescheibe 21 ist weiterhin zumindest eine Referenzmarke 25 vorgesehen, die von einer weiteren Abtasteinrichtung 26 lichtelektrisch abgetastet wird. Im Ausführungsbeispiel sind zwei Referenzmarken 25.1 und 25.2 im äquidistanten Abstand von 180° zueinander angeordnet.

Die Ausbildung von Referenzmarken 25 ist bekannt. Jede Referenzmarke 25 besteht beispielsweise aus einer Folge von transparenten und nicht transparenten Bereichen, so daß bei der Abtastung mit einem entsprechend ausgebildeten Abtastgitter nur an einer vorgegebenen Position ein schmaler Referenzmarkenimpuls R hoher Intensität erzeugt wird.

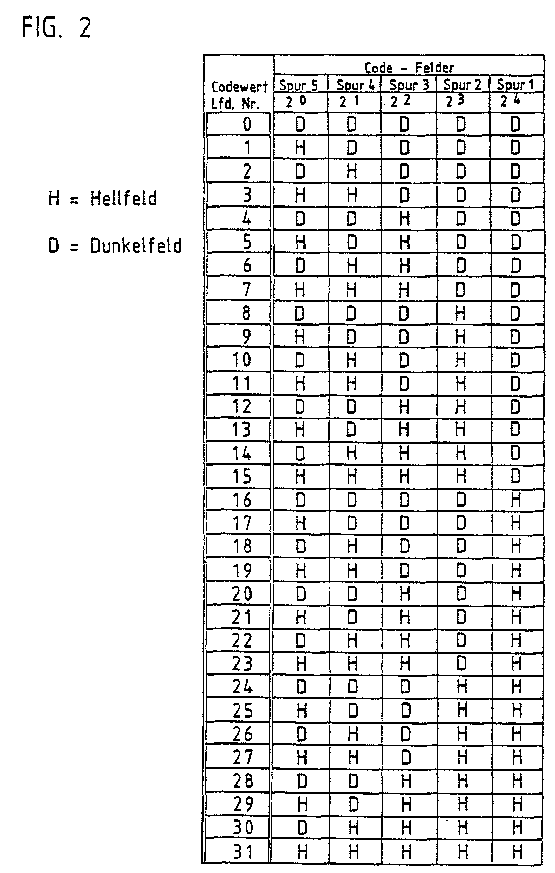

Das Grobmeßsystem 30 besteht aus einer Grobcodescheibe 31, die über ein Untersetzungsgetriebe 40 mit der Welle 1 gekuppelt ist. Die Grobcodescheibe 31 weist einen Code 32 auf, der den Umfang der Grobcodescheibe 31 in eine bestimmt Anzahl S von unterscheidbaren Sektoren unterteilt, wobei der Code 32 jeden Sektors einen absoluten Winkelwert definiert. Der Code 32 wird ebenfalls in bekannter Weise lichtelektrisch von einer Abtasteinrichtung 33 abgetastet. Der Code 32 besteht beispielsweise aus mehreren konzentrisch zur Drehachse verlaufenden Spuren aus transparenten und nicht transparenten Bereichen. Der Code 32 kann bespielsweise ein Gray-Code oder ein Dual-Code sein. Ebenso kann der Code 32 auch ein serieller einspuriger Code sein. Im Ausführungsbeispiel ist der Code 32 ein fünfstelliger Dual-Code, wie er in Figur 2 dargestellt ist, so daß durch die Abtastung der 5 Codespuren der gesamte Umfang der Grobcodescheibe 31 in 32 gleichgroße Sektoren unterteilt wird und jeder Codewert eines Sektors sich vom Codewert eines anderen Sektors unterscheidet.

Die absolute Position der Welle 1 über mehrere Umdrehungen wird durch Kombination der Meßwerte des Feinmeßsystems 20 und des Grobmeßsystems 30 in einer Auswerteeinheit 50 gemäß der genannten DE-34 07 102-C2 gewonnen. Demnach wird bei jedem Abtasten einer Referenzmarke 25 das momentan anstehende Codewort der Grobcodescheibe 31 ausgelesen und der Auswerteeinheit 50 zugeführt. Die Feinposition zwischen zwei Referenzmarken 25 wird durch die Abtastung der inkrementalen Teilung 22 gewonnen, so daß die gesamte absolute Position P durch Kombination des Zählerwertes Z und des Codewortes C gebildet wird. Mit der Referenzmarkenabtastung wird die Abtastung des Codes 32 synchronisiert. Diese Synchronisierung ist so eingestellt, daß ein Referenzmarkenimpuls R dann erzeugt wird, wenn die Mitte eines Sektors des Codes 32 abgetastet wird.

Gemäß der Erfindung ist die Untersetzung 1/U des Untersetzungsgetriebes 40 so gewählt, daß das Getriebe 40 einen minimalen Raum benötigt und einfach sowie kostengünstig herstellbar ist. Die Untersetzung 1/U soll daher annähernd 1 gewählt werden. Bei derart ungewöhnlich kleinen Untersetzungen dreht sich gemäß der Erfindung die Grobcodescheibe 31 zwischen zwei aufeinanderfolgend abgetasteten Referenzmarken 25 um mehrere Sektoren.

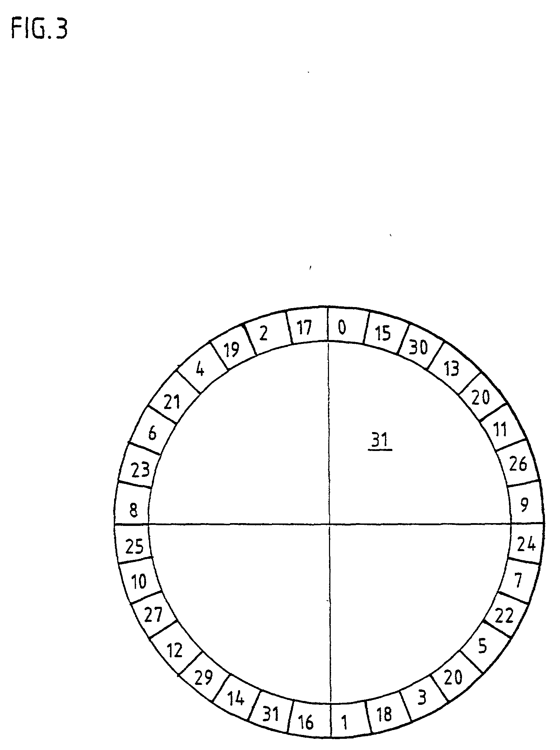

Ist die Untersetzung 1/U des Untersetzungsgetriebes 40 beispielsweise 16:15, so dreht sich die Grobcodescheibe 31 zwischen dem Auftreten von zwei aufeinanderfolgenden Referenzmarkenimpulsen R um jeweils 15 Sektoren weiter. Die 32 Absolutpositionen der 32 Sektoren der Grobcodescheibe 31 werden somit gemäß der in Figur 3 dargestellten Reihenfolge 0 bis 31 ausgelesen. Durch geschickte Wahl der Referenzmarkenanzahl M auf der Feincodescheibe 21, des Untersetzungsverhältnisses 1/U sowie der Sektorenanzahl S ist gewährleistet, daß jeder der Sektoren über den gesamten absoluten Meßbereich (Anzahl der Umdrehungen V der Welle 1) nur ein einziges mal abgetastet und ausgelesen wird. Die erforderliche Anzahl S von Sektoren, das heißt von unterscheidbaren Codierungen des Codes 32 ergibt sich aus dem Produkt von V mit der Anzahl M von Referenzmarken 25; mit V=16 und M=2 ergibt sich S mit 32. Bei einer Untersetzung 1/U=16/15 dreht sich die Feincodescheibe 16 mal, während sich die Grobcodescheibe 15 mal dreht.

Für jede Drehung der Feincodescheibe 21 um das Bogenmaß zwischen zwei Referenzmarken 25 dreht sich die Grobcodescheibe 31 um ein durch das Untersetzungsverhältnis 1/U moduliertes Bogenmaß weiter. Diese Drehung auf eine weitere Grobcodeposition ist gleich (V-λ), mit λ = Schwebungsfaktor. Mit V=16 und 1/U=16/15 ist λ=1. Je nach Wahl des Schwebungsfaktors λ bewegt sich die Grobcodescheibe 31 unterschiedlich schnell relativ zur Feincodescheibe 21 und der Grobcode 32 ist anders angeordnet. Die Schwebung gemäß der Erfindung wird durch die allgemeine Formel ausgedrückt:

$$U=(V-\lambda)/V$$

wobei der Schwebungsfaktor λ ganzzahlige Werte annimmt und (V-λ) ungleich 1 ist. Vorteilhafterweise wird die Grobcodescheibe 31 relativ zur Feincodescheibe 21 in leichter Untersetzung oder Übersetzung, das heißt mit kleinem negativen oder positiven Schwebungsfaktor λ zueinander angetrieben. Je kleiner der Betrag des Schwebungsfaktors λ, desto kleiner ist der Platzverbrauch des Untersetzungsgetriebes 40, da Antrieb und Abtrieb etwa gleich groß ausgeführt werden können, wodurch die Vorrichtung einstufig und sehr kompakt realisierbar ist. $\lambda=\pm1$ ist der optimale und angestrebte Wert. (V-$\lambda$) ist gemäß der Erfindung ungleich 1 und gibt die Anzahl der Sektoren an, die zwischen zwei Referenzmarken 25 durchlaufen werden. Sollen mehrere Umdrehungen V der Welle 1 absolut erfaßt werden, dann ist V größer als 1 und das Getriebe 40 sollte so ausgelegt sein, daß 1/U kleiner als 2 ist mit $\lambda$ kleiner als V/2.

Die zulässigen Werte der Schwebungsfaktoren $\lambda$ ergeben sich aus folgenden Bedingungen:

Sowohl die Zählerzahl (V-$\lambda$) zur Nennerzahl V als auch die Zählerzahl (V-$\lambda$) zur Anzahl von Referenzmarken M muß teilerfremd sein. Das bedeutet, daß die zwei Zahlen (V-$\lambda$) und V sowie (V-$\lambda$) und M jeweils keinen gemeinsamen Teiler außer 1 haben dürfen. Nur wenn diese doppelte Teilerfremdheit gegeben ist, kann eine eindeutige Zuordnung der absoluten Positionen aus dem Code 32 erhalten werden, wobei jeder der S Sektoren die V Umdrehungen der Welle 1 ein einziges Mal ausgelesen wird und somit S unterschiedliche absolute Codewerte C an die Auswerteeinheit 50 gelangen.

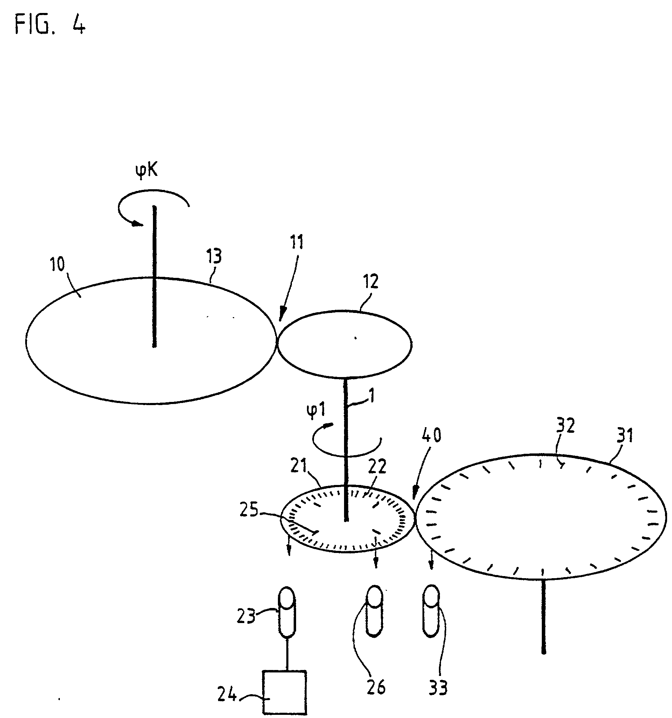

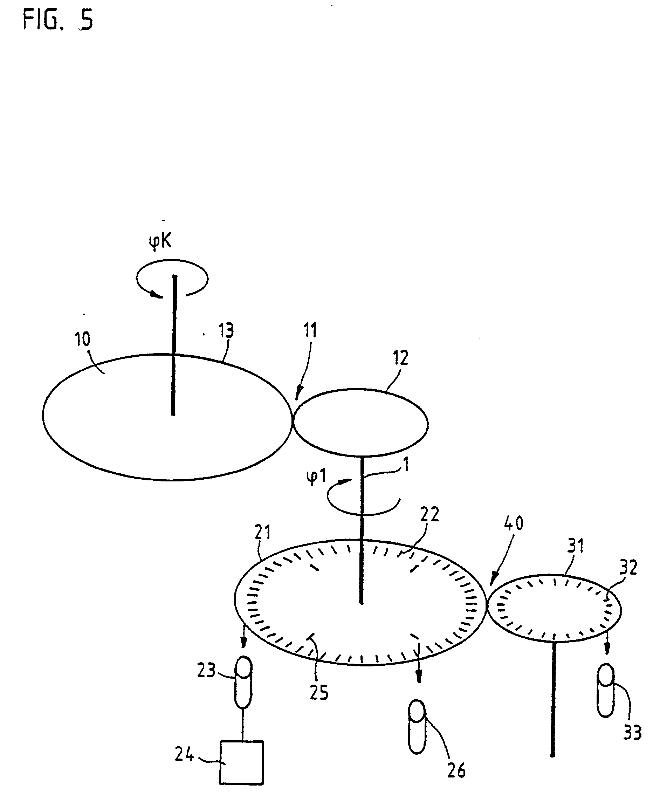

Die erfindungsgemäß ausgebildete Winkelmeßvorrichtung gemäß Figur 1 ist besonders vorteilhaft einsetzbar, um eine Umdrehung eines Körpers 10 absolut zu messen. In den Figuren 4 und 5 ist der Aufbau einer derartigen Vorrichtung schematisch dargestellt. Bei dem Ausführungsbeispiel gemäß Figur 4 wird zur Erfassung einer einzigen Umdrehung des Körpers 10 die Welle 1 vom Körper 10 über ein Getriebe 11 übersetzt angetrieben. Die Grobcodescheibe 31 wird relativ zur Feincodescheibe 21 über das Getriebe 40 untersetzt angetrieben. Der Körper 10 ist ein Rotationskörper, der sich um eine Drehachse dreht. Der augenblickliche Drehwinkel des Körpers 10 ist mit $\varphi K$ bezeichnet. Die Welle 1 wird vom Körper 10 über das Getriebe 11 mit dem Übersetzungsverhältnis 1/V angetrieben, wobei 1/V kleiner 1 ist und einen Stammbruch bildet. Das Getriebe 10 ist in Figur 4 nur schematisch als antreibender Körper 10 mit einem Zahnkranz 13 und Erfassende 12 dargestellt. Das Getriebe 10 besteht in bekannter Weise aus formschlüssig ineinandergreifenden Mitteln, beispielsweise aus Zahn- oder Reibrädern. Die Erfassende 12 ist beispielsweise ein Ritzel, das mit der Feincodescheibe 21 an der Welle 1 angebracht ist. Dieser Antrieb ist hochpräzise und spielfrei und gestattet so eine hochgenaue Übertragung der Drehung des Körpers 10 auf die Erfassende 12 und somit auf die Welle 1. Die Übertragungsgenauigkeit ist nomalerweise in der Größenordnung der Winkelauflösung der Vorrichtung. Der augenblickliche Drehwinkel der Welle 1 ist mit $\varphi1$ bezeichnet. Die Welle 1 treibt über formschlüssige Mittel 40 die Grobcodescheibe 31 an. Da die Grobcodescheibe 31 die Position der in relativ großen Bogenmaßen zueinander angeordneten Referenzmarken 25 wiedergibt, reicht es, daß dieses zweite Getriebe 40 von Standardgenauigkeit ist, wodurch die Vorrichtung besonders kostengünstig realisierbar ist. Vorteilhafte Übersetzungsverhältnisse 1/V sind beispielsweise 1/12 oder 1/8, wobei sich der Körper 10 ein mal und die Welle 1 zwölf oder acht mal dreht. Die dafür zu verwendenden hochpräzisen und spielfreien Getriebe 11 sind dem Fachmann bekannt. Anwendungsspezifisch lassen sich verschiedene Übersetzungsverhältnisse realisieren. Die Winkelauflösung des Drehwinkels $\varphi K$ des Körpers 10 wächst mit steigendem V, bei fester Anzahl von Zählschritten der inkrementalen Teilung 22 pro Umdrehung der Feincodescheibe 21.

Die Welle 1 dreht sich mit steigendem V immer schneller relativ zum Körper 10. Getriebe 11 mit hohem V sind meist mehrstufig, wodurch sie teuer sind und viel Platz benötigen. Aus Kosten- und Platzgründen sind somit Getriebe 11 mit relativ geringer Übersetzung, also mit kleinem V zu empfehlen, da diese als einstufige Getriebe realisierbar sind.

Es liegt auch im Rahmen der Erfindung Getriebe 11 mit einem Übersetzungsverhältnis von 1:1 oder mit einer Untersetzung einzusetzen. allerdings ist insbesondere bei Verwendung von Untersetzungsgetrieben die erreichbare Winkelauflösung relativ schlecht (bei gleichbleibender Anzahl von inkrementalen Teilungseinheiten auf der Feincodescheibe 21).

Bei dem Ausführungsbeispiel gemäß Figur 5 wird im Gegensatz zu den bisherigen Beispielen die Grobcodescheibe 31 übersetzt angetrieben, das heißt 1/U ist kleiner als 1.

Wie bereits erläutert wurde, ist U in Abhängigkeit von V und des Schwebungsfaktors $\lambda$ variierbar. Dies wird durch die allgemeine Formel U=(V-$\lambda$)/V ausgedrückt, wobei gemäß der Erfindung $\lambda$ ganzzahlige Werte annimmt und (V-$\lambda$) ungleich eins ist. Für eine eindeutige Zuordnung der Drehzustände der Feincodescheibe 21 relativ zur Grobcodescheibe 31 müssen die Zahlen (V-$\lambda$) und V teilerfremd sein. Der Schwebungsfaktor $\lambda$ kann somit nur bestimmte Werte einnehmen.

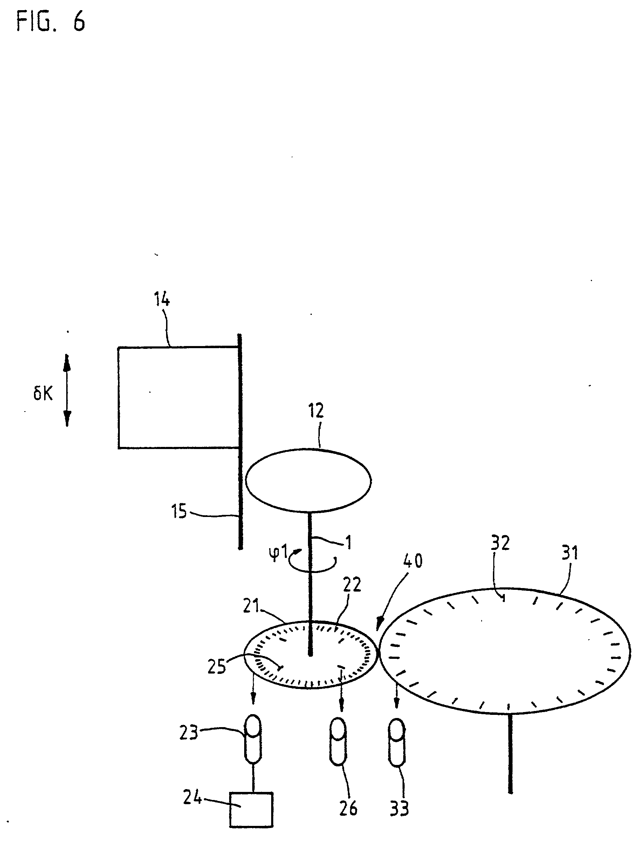

Figur 6 zeigt die Verwendung der erfindungsgemäßen Winkelmeßeinrichtung gemäß Figur 1 zur Aufnahme von Translationsbewegungen. Während in den Beispielen gemäß den Figuren 4 und 5 beispielsweise ein Zahnkranz 13 am Körper 10 zur Übertragung der Drehbewegung auf die Welle 1 verwendet wird, erfolgt die Aufnahme der Translationsbewegung $\delta K$ des Körpers 14 bei Figur 6 beispielsweise durch eine Zahnstange 15.

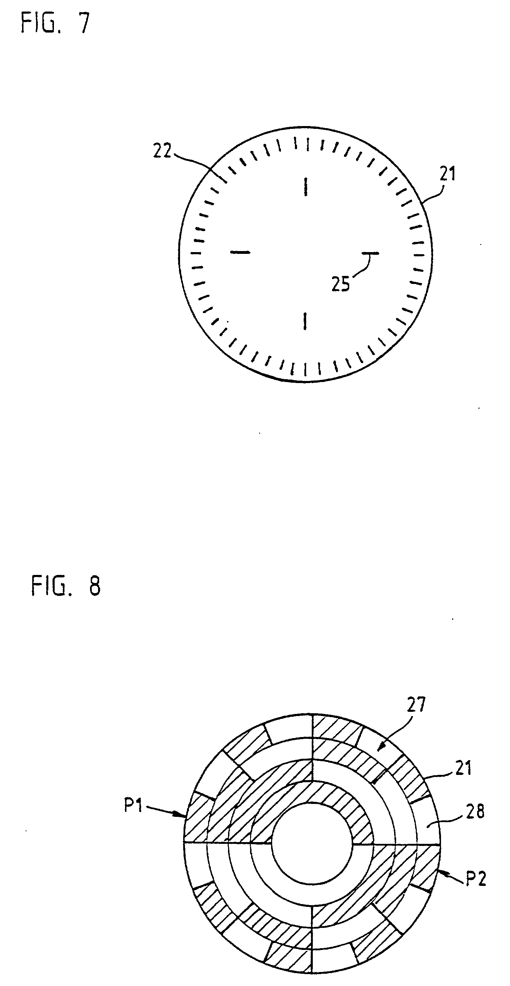

Die Figuren 7 und 8 zeigen den Aufbau zweier Ausführungsformen einer Feincodescheibe 21. Je nach gewünschter Auflösung weist die Feincodescheibe 21 eine inkrementale Teilung 22 mit zueinander äquidistanten Teilungsmarkierungen auf.

Die 4 Referenzmarken 25 der Feincodescheibe 21 gemäß Figur 7 sind im äquidistanten Abstand oder im Bogenmaß von 90° zueinander angeordnet.

Anwendungsspezifisch sind beliebige Anordnungen und Anzahlen von Referenzmarken 25 realisierbar. Vorteilhafterweise sind die Referenzmarken 25 in gleich großen Bogenmaßen zueinander angeordnet, die Grobcodepositionen C mit steigenden oder fallenden Grobcodewerten der Grobcodescheibe 31 auslesen. In Abhängigkeit vom gewählten Unter- oder Übersetzungsverhältnis 1/U sind die nacheinander auszulesenden Codewerte C ebenfalls in gleich großen Bogenmaßen auf der Grobcodescheibe 31 angeordnet.

Sind die Referenzmarken in ungleichen Bogenmaßen angeordnet, dann sind auch die nacheinander auszulesenden Codewerte C in ungleichmäßig großen Bogenmaßen angeordnet.

Anstelle der Feincodescheibe 21 mit Referenzmarken kann auch eine Feincodescheibe 21 gemäß Figur 8 eingesetzt werden. Diese Feincodescheibe 21 weist einen absoluten Code 27, beispielsweise einen mehrspurigen Gray- oder Dualcode auf, wobei an vorgegebenen absoluten Positionen P1, P2 einer Umdrehung der Feincodescheibe 21 die Ablesung der Grobcodescheibe 31 synchronisiert wird. Die Anzahl dieser vorgegebenen Positionen P1, P2 entspricht dabei der Zahl M gemäß obiger Ausführungen. Die feinste Spur 28 des Codes 27 kann dabei als inkrementale Teilung betrachtet werden und entsprechend ausgewertet werden, es kann aber auch eine separate inkrementale Teilung vorgesehen sein. Ebenso kann der Code 27 auch ein einspuriger Kettencode sein.

Das Erfassen der Referenzmarken 25, des Codes 27, der inkrementalen Teilung 22 sowie des Codes 32 erfolgt vorteilhafterweise berührungs- und verschleißfrei. Das Abtasten kann beispielsweise im Auflicht- oder im Durchlichtverfahren mit oder ohne zusätzlicher Blenden in bekannter Weise erfolgen. Die Abtastung kann aber auch kapazitiv, magnetisch oder induktiv erfolgen.

Nachfolgend zwei Zahlenbeispiele zur Realisierung der Erfindung:

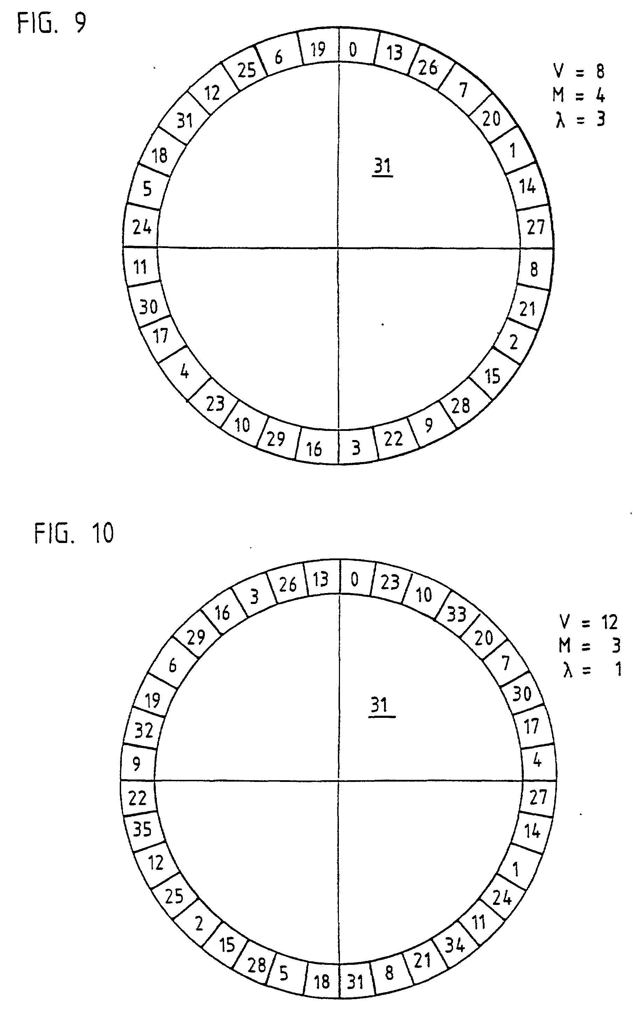

Mit $V=2^3=8$ und bei Verwendung einer Anzahl $M=2^2=4$ Referenzmarken 25 ergibt sich die erforderliche Anzahl von Sektoren S aus dem Produkt $(V \cdot M) =2^5=32$. Zwischen zwei aufeinanderfolgenden Referenzmarken 25 lassen sich beispielsweise $2^{10}=1024$ inkrementale Teilungsperioden der Teilung 22 abtasten. Während der acht absolut zu erfassenden Umdrehungen der Welle 1 werden $2^5$ Referenzmarken abgetastet, wobei die Absolutpositionen durch $2^5$ Grobcodewerte C angezeigt werden. Die hierbei verwendete Grobcodescheibe 31 ist in Figur 9 dargestellt. Mit U=5/8 ergibt sich ein Schwebungsfaktor $\lambda=3$. Wenn sich bei diesen Verhältnissen die Feincodescheibe 21 um 90° von einer Referenzmarke 25 zur nächsten Referenzmarke 25 bewegt, so bewegt sich die Grobcodescheibe 31 um (5/8)· 90°=56,25° weiter, was 5 Grobcodewerte, also 5 Sektoren entspricht. Bei einer Bewegung der Feincodescheibe 21 im Uhrzeigersinn um 90° bewegt sich die Grobcodescheibe 31 entgegen des Uhrzeigersinns um 5 Sektoren, beispielsweise von dem Codewert C=0 auf den Codewert C=1. Im umgekehrten Sinne bewegt sich die Grobcodescheibe 31 um 5 Sektoren von dem Codewert C=0 auf den Codewert C=31.

Beim zweiten Beispiel gemäß Figur 10 ist V=12; U=11/12 (also annähernd 1); M=3; $\lambda=1$. Die Anzahl der erforderlichen Grobcodewerte C ist $(V \cdot M)=36$. Zwischen zwei aufeinanderfolgenden Referenzmarken 25 werden beispielsweise 3.600 Teilungsperioden der inkrementalen Teilung 22 abgetastet. Während der 12 absolut zu messenden Umdrehungen der Welle 1 werden 36 aufeinanderfolgende Referenzmarken 25 abgetastet, wobei die Absolutpositionen durch $2^5$ Grobcodewert C angezeigt werden. Bei diesen Verhältnissen würde eine Winkelauflösung des Körpers 10, dessen Absolutposition gemäß Figur 4 innerhalb einer Umdrehung mit 1/V=1/12 zu erfassen ist, 10 Winkelsekunden betragen. Wenn sich die Feincodescheibe 21 um 120° von einer Referenzmarke 25 zur nächsten Referenzmarke 25 bewegt, so bewegt sich die Grobcodescheibe 31 um (11/12)·120°=110° entsprechend 11 Sektoren weiter. Bei einer Bewegung der Feincodescheibe 21 im Uhrzeigersinn um 120° bewegt sich die Grobcodescheibe 31 entgegen des Uhrzeigersinns um 11 Sektoren, beispielsweise vom Codewert C=0 auf den Codewert C=1. Im umgekehrten Sinne bewegt sich die Grobcodescheibe 31 um 11 Sektoren von dem Codewert C=0 auf den Codewert C=35.

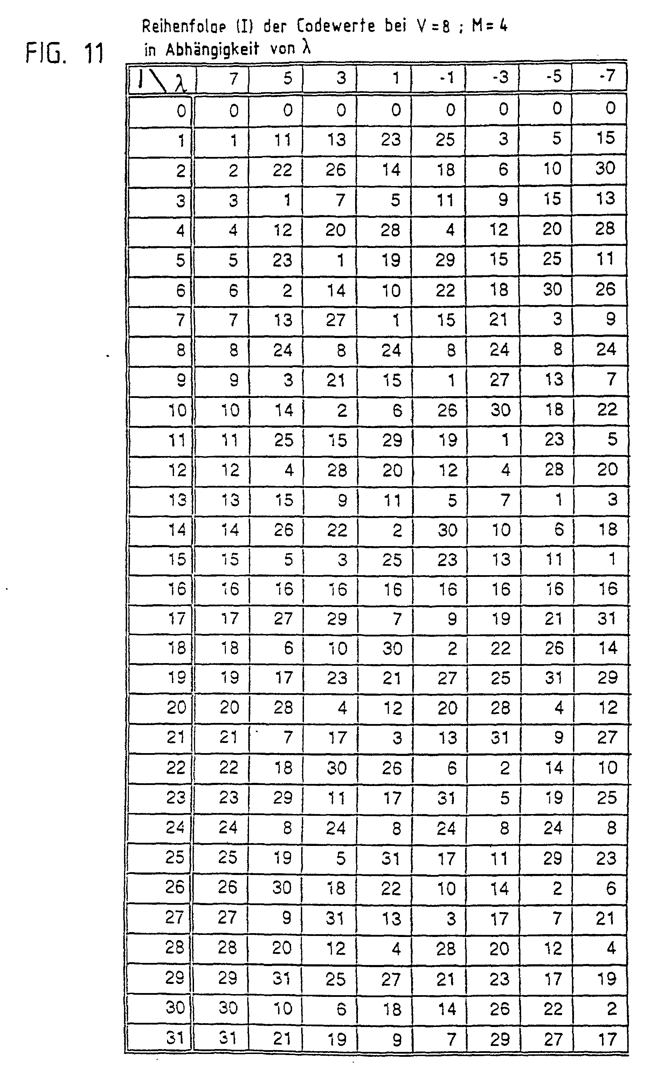

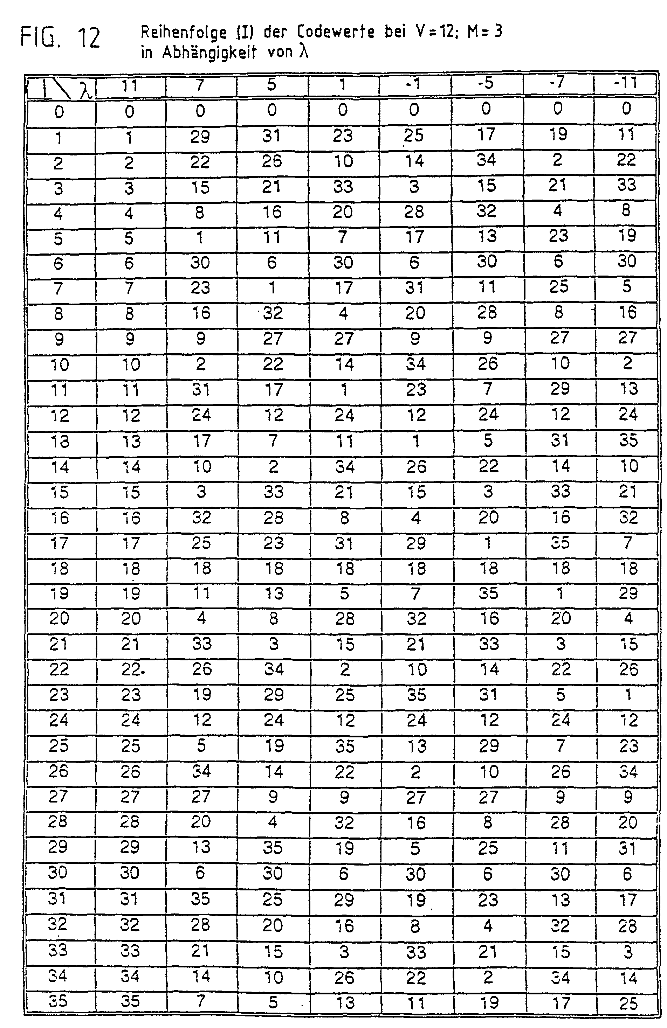

Die Figuren 11 und 12 zeigen beispielhafte Ausführungsformen des Codes 32 der Grobcodescheibe 31 für zwei unterschiedliche Datensätze von V und M, wobei die Codewerte C in Funktion des Schwebungsfaktors $\lambda$ modulierbar sind. Je nach dem Schwebungsfaktor $\lambda$ bewegt sich die Grobcodescheibe 31 unterschiedlich schnell zur Feincodescheibe 21 und die Reihenfolge der Codewerte C verläuft anders, um die Anzahl der abgetasteten Referenzmarken 25 durch die Codewerte C eindeutig anzuzeigen. In den Figuren 11 und 12 sind die möglichen Abfolgen der Codewerte C gezeigt. Bei angestrebter geringer Untersetzung ist $\lambda=1$. Dabei bewegt sich die Grobcodescheibe beim Beispiel nach Figur 11 zwischen zwei Referenzmarken um 7 Sektoren und beim Beispiel nach Figur 12 um 11 Sektoren weiter.

Wie in Figur 1 dargestellt ist, wird die absolute Position P durch Kombination des Meßwertes Z des Feinmeßsystems 20 und des Meßwertes C des Grobmeßsystems 30 gebildet. Dabei wird der Meßwert Z durch Abtastung der inkrementalen Teilung 22 gewonnen und die Signale der Referenzmarken 25 oder des Codes 27 takten das Abtasten des Codes 32, so daß die Anzahl passierter Referenzmarken 25 oder absoluter Positionen P1, P2 durch den zuletzt abgetasteten Codewert C angezeigt wird. Der Meßwert Z gibt einen Feinwert bezüglich der zuletzt abgetasteten Referenzmarke 25 oder Position P1, P2 an. Der Meßwert Z wird beim Abtasten einer Referenzmarke 25 oder einer Position P1, P2 auf Null gesetzt, wobei der abgetastete Codewert C gespeichert wird und beim Abtasten einer weiteren Referenzmarke 25 oder Position P1, P2 geändert wird. Der Meßwert P ist beispielsweise ein 17-stelliges Codewort. Bei jedem Referenzimpuls R wird ein 5-stelliges Codewort als Codewert C ausgetastet und in die fünf höchstwertigen Stellen eines 17-stelligen Zählers 50 übertragen. Gleichzeitig werden die 12 niedrigstwertigen Stellen des Zählers 50 auf Null zurückgesetzt.

Um bei den Übergängen von einem Codewert C auf den nächsten Codewert C keine Fehlmessungen zu bekommen, ist es vorteilhaft die Kombination von Feinmeßwert Z und Grobcodewert C nach an sich bekannten Methoden zu synchronisieren. Würden die niedrigsten 12 Bits des Zählers 50 bei jedem Referenzimpuls R auf Null gesetzt, dann könnte bei abwärts laufendem Winkelwert je nach Laufzeitunterschiede der Signalauswertung des Feinmeßsystems 20 und des Grobmeßsystems 30 oder aufgrund von Ablesefehlern ein später als der Zählerunterlauf (von 12. nach 13. Bit) eintreffender Setbefehl für einen neuen Codewert C die Absolutposition P einen um einen Codewert C zu hohen Wert haben. Um diese Mehrdeutigkeit zu vermeiden, werden die niedrigsten 12 Bits des Zählers 50 bei jedem Referenzimpuls R auf den Wert 1 00 000 000 000 und nicht auf Null gesetzt. Durch diese Addition des Feinmeßwertes Z um (1/2 mal Bogenmaß zwischen zwei Referenzmarken 25) wird vermieden, daß unmittelbar nach einem Referenzimpuls R ein Übertrag von der 12. nach der 13. Zählerstelle vorkommt. Derartige Methoden zur Synchronisation zwischen einem Fein-und Grobmeßwert sind beispielsweise aus der DE-27 58 525-B1, DE-29 38 318-C3, DE-33 22 897-C2 und der DE-37 34 938-C2 bekannt, weshalb sich weitere Ausführungen hierzu erübrigen.

Wie bereits erläutert, ist die Auslesung der Codewerte C durch das Feinmeßsystem 20 derart synchronisiert, daß die Auslesung jeweils in der Mitte eines Sektors des Codes 32 erfolgt. Um dies zu gewährleisten, sind vier Justiermarken vorgesehen. Eine Justiermarke befindet sich auf der Abtasteinrichtung 26, eine auf der Feincodescheibe 21, eine auf der Abtasteinrichtung 33 und eine auf der Grobcodescheibe 31. Während der Montage der Winkelmeßvorrichtung wird das Getriebe 40 arretiert und die Codescheiben 21, 31 so verdreht, daß jeweils die Justiermarke der Codescheiben 21, 31 der entsprechenden Justiermarke der Abtasteinrichtung 26, 33 gegenübersteht. In dieser Stellung erfolgt die Fixierung der Codescheiben 21, 31 relativ zum Getriebe 40.

**Patentansprüche**

1. Vorrichtung zur Bestimmung der Position (P) eines Körpers (1, 10, 14) mit einem Feinmeßsystem (20) und einem damit gekoppelten Grobmeßsystem (30), bei der eine Grobcodescheibe (31) des Grobmeßsystems (30) mit einer Winkelgeschwindigkeit umläuft, die sich von der Winkelgeschwindigkeit einer Feincodescheibe (21) des Feinmeßsystems (20) unterscheidet, bei der weiterhin die Abtastung der Grobcodescheibe (31) von einem Referenzsignal (R) des Feinmeßsystems (20) gesteuert wird, indem jeweils an zumindest einer vorgegebenen Referenzposition (25, P1, P2) der Feincodescheibe (21) ein Codewert (C) des Codes (32) der Grobcodescheibe (31) abgetastet und an eine Auswerteeinheit (50) abgegeben wird, in der die Position (P) des Körpers (1, 10, 14) durch Kombination eines Meßwertes (Z) des Feinmeßsystems (20) und eines Meßwertes (C) des Grobmeßsystems (30) gewonnen wird, wobei der Code (32) der Grobcodescheibe (31) den Umfang der Grobcodescheibe (31) in mehrere (S) unterscheidbare Sektoren unterteilt und der Codewert (C) jeden Sektors eine grobe absolute Position des zu messenden Körpers (1, 10, 14) bestimmt, dadurch gekennzeichnet, daß sich die Winkelgeschwindigkeit der Grobcodescheibe (31) von der Winkelgeschwindigkeit der Feincodescheibe (21) nur geringfügig unterscheidet, und daß sich die Grobcodescheibe (31) jeweils zwischen zwei aufeinanderfolgend abgetasteten und weitergegebenen Codewerten (C) um mehrere Sektoren dreht.

2. Vorrichtung nach Anspruch 1, dadurch gekennzeichnet, daß die Feincodescheibe (21) drehfest mit einer Welle (1) verbunden ist, deren Drehwinkel ($\varphi$1) über mehrere (V) Umdrehungen absolut erfaßt wird, wobei innerhalb einer Umdrehung der Feincodescheibe M Referenzsignale (R) erzeugt werden und die Grobcodescheibe (31) M.V=S Sektoren mit verschiedenen Codewerten (C) aufweist und die Grobcodescheibe (31) von der Welle (1) über ein Unter- oder Übersetzungsgetriebe (40) mit einem Unter- oder Übersetzungsverhältnis von 1/U angetrieben wird, wobei folgende Beziehung gilt:

$$U=(V-\lambda)/V$$

mit $\lambda$ = ganzzahliger Schwebungsfaktor und (V-$\lambda$) ungleich 1.

3. Vorrichtung nach Anspruch 2, dadurch gekennzeichnet, daß (V-$\lambda$) zu V und (V-$\lambda$) zu M jeweils teilerfremd sind.

4. Vorrichtung nach Anspruch 2 oder 3, dadurch gekennzeichnet, daß $\lambda$=+1 oder $\lambda$=-1 ist.

5. Vorrichtung nach Anspruch 2 oder 3, dadurch gekennzeichnet, daß das Unter- oder Übersetzungsverhältnis 1/U kleiner als 2 ist und der Schwebungsfaktor $\lambda$ kleiner als V/2 ist.

6. Vorrrichtung nach einem der vorhergehenden Ansprüche, dadurch gekennzeichnet, daß die Feincodescheibe (21) eine inkrementale Teilung (22) und an zumindest einer Referenzposition eine Referenzmarke (25) aufweist.

7. Vorrichtung nach Anspruch 6, dadurch gekennzeichnet, daß die Feincodescheibe (21) mehrere in äquidistanten Winkelabständen angeordnete Referenzmarken (25) aufweist.

8. Vorrichtung nach einem der Ansprüche 1 bis 5, dadurch gekennzeichnet, daß die Feincodescheibe (21) einen absoluten Code (32) aufweist, und daß ein Referenzimpuls (R) an zumindest einer vorgegebenen absoluten Referenzposition (P1, P2) innerhalb einer Umdrehung der Feincodescheibe (21) erzeugt wird.

9. Vorrichtung nach Anspruch 2, dadurch gekennzeichnet, daß die Welle (1) über ein Getriebe (11) von einem Körper (10, 14) übersetzt angetrieben wird.

10. Vorrichtung nach Anspruch 9, dadurch gekennzeichnet, daß der Körper ein drehbarer Körper (10) ist, dessen Position (P) innerhalb einer Umdrehung absolut erfaßt wird, wobei das Übersetzungsverhältnis des Getriebes (11) 1/V ist.

11. Verfahren zur Bestimmung der Position (P) eines Körpers (1, 10, 14) mit einem Feinmeßsystem (20) und einem damit gekoppelten Grobmeßsystem (30), bei der eine Grobcodescheibe (31) des Grobmeßsystems (30) mit einer Winkelgeschwindigkeit umläuft, die sich von der Winkelgeschwindigkeit einer Feincodescheibe (21) des Feinmeßsystems (20) unterscheidet, bei der weiterhin die Abtastung der Grobcodescheibe (31) von einem Referenzsignal (R) des Feinmeßsystems (20) gesteuert wird, indem jeweils an zumindest einer vorgegebenen Referenzposition (25, P1, P2) der Feincodescheibe (21) ein Codewort (C) des Codes (32) der Grobcodescheibe (31) abgetastet und an eine Auswerteeinheit (50) abgegeben wird, in der die Position (P) des Körpers (1, 10, 14) durch Kombination eines Meßwertes (Z) des Feinmeßsystems (20) und eines Meßwertes (C) des Grobmeßsystems (30) gewonnen wird, wobei der Code (32) der Großcodescheibe (31) den Umfang der Grobcodescheibe (31) in mehrere (S) unterscheidbare Sektoren unterteilt und der Codewert (C) jeden Sektors eine grobe absolute Position des zu messenden Körpers (1, 10, 14) bestimmt, dadurch gekennzeichnet, daß die Grobcodescheibe (31) mit einer Winkelgeschwindigkeit umläuft, die sich von der Winkelgeschwindigkeit der Feincodescheibe (21) nur geringfügig unterscheidet, und daß sich die Grobcodescheibe (31) jeweils zwischen zwei aufeinanderfolgend abgetasteten und weitergegebenen Codewerten (C) um mehrere Sektoren dreht.

**Claims**

1. Device for determining the position (P) of a body (1, 10, 14), said device having a precision measuring system (20) and a rough measuring system (30) coupled thereto, in which device a rough measurement code disk (31) of the rough measuring system (30) revolves at an angular velocity which differs from the angular velocity of a precision measurement code disk (21) of the precision measuring system (20), and in which device furthermore the scanning of the rough measurement code disk (31) is controlled by a reference signal (R) of the precision measuring system (20), by a code value (C) of the code (32) of the rough measurement code disk (31) being scanned at at least one predetermined reference position (25, P1, P2) of the precision measurement code disk (21) and passed to an evaluating unit (50), in which the position (P) of the body (1, 10, 14) is obtained by combining a measured value (Z) of the precision measuring system (20) and a measured value (C) of the rough measuring system (30), the code (32) of the rough measurement code disk (31) dividing the perimeter of the rough measurement code disk (31) into a plurality (S) of distinguishable sectors, and the code value (C) of each sector determining a rough absolute position of the body (1, 10, 14) to be measured, **characterised in that** the angular velocity of the rough measurement code disk (31) differs only slightly from the angular velocity of the precision measurement code disk (21), and in that the rough measurement code disk (31) revolves around a plurality of sectors respectively between two successively scanned and passed-on code values (C).

2. Device according to claim 1, **characterised in that** the precision measurement code disk (21) is securely coupled to a shaft (1) to rotate with same, the rotation angle ($\varphi 1$) of which shaft is detected absolutely via a plurality (V) of revolutions, M reference signals being generated within one revolution of the precision measurement code disk, and the rough measurement code disk (31) having M.V=S sectors with various code values (C) and the rough measurement code disk (31) being driven by the shaft (1) via a step-down or step-up gear (40) with a step-down ratio or gear ratio of 1/U, the following relationship being valid:

$$U=(V-\lambda)/V$$

with $\lambda$ = a whole-number beat factor and (V-$\lambda$) not equal to 1.

3. Device according to claim 2, **characterised in that** (V-$\lambda$) to V and (V-$\lambda$) to M are respectively relatively prime.

4. Device according to claim 2 or 3, **characterised in that** λ=+1 or λ=-1.

5. Device according to claim 2 or 3, **characterised in that** the step-down ratio or gear ratio 1/U is smaller than 2 and the beat factor λ is smaller than V/2.

6. Device according to one of the preceding claims, **characterised in that** the precision measurement code disk (21) has an incremental division (22) and a reference mark (25) at at least one reference position.

7. Device according to claim 6, **characterised in that** the precision measurement code disk (21) has reference marks (25) disposed at equidistant angular spacings.

8. Device according to one of claims 1 to 5, **characterised in that** the precision measurement code disk (21) has an absolute code (32), and in that a reference pulse (R) is generated at at least one predetermined absolute reference position (P1, P2) within one revolution of the precision code disk (21).

9. Device according to claim 2, **characterised in that** the shaft (1) is driven, geared via a gear system (11), by a body (10, 14).

10. Device according to claim 9, **characterised in that** the body is a rotatable body (10), the position (P) of which is detected absolutely within one revolution, the gear ratio of the gear system (11) being 1/V.

11. Method of determining the position (P) of a body (1, 10, 14) using a precision measuring system (20) and a rough measuring system (30) coupled thereto, in which a rough measurement code disk (31) of the rough measuring system (30) revolves at an angular velocity which differs from the angular velocity of a precision measurement code disk (21) of the precision measuring system (20), and in which furthermore the scanning of the rough measurement code disk (31) is controlled by a reference signal (R) of the precision measuring system (20), by a code value (C) of the code (32) of the rough measurement code disk (31) being scanned at at least one predetermined reference position (25, P1, P2) of the precision measurement code disk (21) and passed to an evaluating unit (50), in which the position (P) of the body (1, 10, 14) is obtained by combining a measured value (Z) of the precision measuring system (20) and a measured value (C) of the rough measuring system (30), the code (32) of the rough measurement code disk (31) dividing the perimeter of the rough measurement code disk (31) into a plurality (S) of distinguishable sectors, and the code value (C) of each sector determining a rough absolute position of the body (1, 10, 14) to be measured, **characterised in that** the rough measurement code disk (31) revolves at an angular velocity which differs only slightly from the angular velocity of the precision measurement code disk (21), and in that the rough measurement code disk (31) revolves around a plurality of sectors respectively between two successively scanned and passed-on code values (C) .

**Revendications**

1. Dispositif pour déterminer la position (P) d'un corps (1, 10 14), comportant un système de mesure de précision (20) ainsi qu'un système de mesure grossière (30) couplé à celui-ci, dans lequel un disque codeur grossier (31) du système de mesure grossière (30) tourne à une vitesse angulaire différente de celle d'un disque codeur de précision (21) du système de mesure de précision (20), dans lequel le palpage du disque codeur grossier (31) est commandé par un signal de référence (R) du système de mesure de précision (20), une valeur de code (C) du code (32) de disque codeur grossier (31) étant lue en au moins une position de référence (25, P1, P2) donnée du disque codeur de précision (31) et étant délivrée à une unité de traitement (50), dans laquelle la position (P) du corps (1, 10, 14) est calculée par combinaison d'une valeur de mesure (Z) du système de mesure de précision (20) et d'une valeur de mesure (C) du système de mesure grossier (30), le code (32) du disque codeur grossier (31) divisant la circonférence dudit disque codeur grossier (31) en plusieurs (S) secteurs distincts et la valeur de code (C) de chaque secteur déterminant une position absolue grossière du corps (1, 10, 14) à mesurer, caractérisé en ce que la vitesse angulaire du disque codeur grossier (31) ne diffère que faiblement de la vitesse angulaire du disque codeur de précision (21) et en ce que le disque codeur grossier (31) tourne chaque fois de plusieurs secteurs entre deux valeurs de code (C) palpées et transmises consécutivement.

2. Dispositif selon la revendication 1, caractérisé en ce que le disque codeur de précision (21) est solidaire en rotation d'un arbre (1), dont l'angle de rotation (φ1) est mesuré de manière absolue sur plusieurs (V) révolutions, M signaux de référence (R) étant produits au cours d'une révolution du disque codeur de précision (21), et le disque codeur grossier (31) comportant M.V=S secteurs avec différentes valeurs de code (C) et le disque codeur grossier (31) étant entraîné en rotation par l'arbre (1), par l'intermédiaire d'un engrenage réducteur ou multiplicateur (40), avec un rapport de réduction ou de multiplication 1/U, avec pour relation:

$$U = (V-\lambda) / V$$

avec $\lambda$ = facteur de battement entier et $(V-\lambda)$ différent de 1.

3. Dispositif selon la revendication 2, caractérisé en ce que $(V-\lambda)$ sur V et $(V-\lambda)$ sur M sont premiers.

4. Dispositif selon la revendication 2 ou 3, caractérisé en ce que $\lambda$ = +1 ou $\lambda$ = -1.

5. Dispositif selon la revendication 2 ou 3, caractérisé en ce que le rapport de réduction ou de multiplication 1/U est inférieur à 2 et que le facteur de battement $\lambda$ est inférieur à V/2.

6. Dispositif selon une des revendications précédentes, caractérisé en ce que le disque codeur de précision (21) comporte une division incrémentale (22) et comporte un repère de référence (25) en au moins une position de référence.

7. Dispositif selon la revendication 6, caractérisé en ce que le disque codeur de précision (21) comporte plusieurs repères de référence (25) avec des écarts angulaires constants.

8. Dispositif selon une des revendications 1 à 5, caractérisé en ce que le disque codeur de précision (21) comporte un code absolu (32) et en ce qu'une impulsion de référence (R) est produite en au moins position de référence (P1, P2) absolue prédéterminée au cours d'une révolution du disque codeur de précision (21).

9. Dispositif selon la revendication 2, caractérisé en ce que l'arbre (1) est entraîné par un corps (10, 14) avec multiplication par l'intermédiaire d'un engrenage (11).

10. Dispositif selon la revendication 9, caractérisé en ce que le corps est un corps tournant (10), dont la position (P) est mesurée de manière absolue au cours d'une révolution, le rapport de multiplication de l'engrenage (11) étant 1/V.

11. Procédé pour déterminerla position (P) d'un corps (1, 10, 14) comportant un système de mesure de précision (20) ainsi qu'un système de mesure grossière (30) couplé à celui-ci, dans lequel un disque codeur grossier (31) du système de mesure grossière (30) tourne à une vitesse angulaire différente de celle d'un disque codeur de précision (21) du système de mesure de précision (20), dans lequel le palpage du disque codeur grossier (31) est commandé par un signal de référence (R) du système de mesure de précision (20), une valeur de code (C) du code (32) de disque codeur grossier (31) étant lue en au moins une position de référence (25, P1, P2) donnée du disque codeur de précision (31) et étant délivrée à une unité de traitement (50), dans laquelle la position (P) du corps (1, 10, 14) est calculée par combinaison d'une valeur de mesure (Z) du système de mesure de précision (20) et d'une valeur de mesure (C) du système de mesure grossier (30), le code (32) du disque codeur grossier (31) divisant la circonférence dudit disque codeur grossier (31) en plusieurs (S) secteurs distincts et la valeur de code (C) de chaque secteur déterminant une position absolue grossière du corps (1, 10, 14) à mesurer, caractérisé en ce que le disque codeur grossier (31) tourne avec une vitesse angulaire qui ne diffère que faiblement de la vitesse angulaire du disque codeur de précision (21) et en ce que le disque codeur grossier (31) tourne chaque fois de plusieurs secteurs entre deux valeurs de code (C) palpées et transmises consécutivement.

FIG. 1

# FIG. 2

H = Hellfeld

D = Dunkelfeld

| Codewert Lfd. Nr. | Code – Felder | | | | |
|---|---|---|---|---|---|
| | Spur 5 $2^0$ | Spur 4 $2^1$ | Spur 3 $2^2$ | Spur 2 $2^3$ | Spur 1 $2^4$ |
| 0 | D | D | D | D | D |
| 1 | H | D | D | D | D |
| 2 | D | H | D | D | D |
| 3 | H | H | D | D | D |
| 4 | D | D | H | D | D |
| 5 | H | D | H | D | D |
| 6 | D | H | H | D | D |
| 7 | H | H | H | D | D |
| 8 | D | D | D | H | D |
| 9 | H | D | D | H | D |
| 10 | D | H | D | H | D |
| 11 | H | H | D | H | D |
| 12 | D | D | H | H | D |
| 13 | H | D | H | H | D |
| 14 | D | H | H | H | D |
| 15 | H | H | H | H | D |
| 16 | D | D | D | D | H |
| 17 | H | D | D | D | H |
| 18 | D | H | D | D | H |
| 19 | H | H | D | D | H |
| 20 | D | D | H | D | H |
| 21 | H | D | H | D | H |
| 22 | D | H | H | D | H |
| 23 | H | H | H | D | H |
| 24 | D | D | D | H | H |
| 25 | H | D | D | H | H |
| 26 | D | H | D | H | H |
| 27 | H | H | D | H | H |
| 28 | D | D | H | H | H |
| 29 | H | D | H | H | H |
| 30 | D | H | H | H | H |
| 31 | H | H | H | H | H |

## FIG.3

FIG. 4

FIG. 5

FIG. 6

FIG. 7

FIG. 8

FIG. 9

V = 8
M = 4
λ = 3

FIG. 10

V = 12
M = 3
λ = 1

FIG. 11 — Reihenfolge (I) der Codewerte bei V=8 ; M=4 in Abhängigkeit von λ

| I \ λ | 7 | 5 | 3 | 1 | -1 | -3 | -5 | -7 |
|---|---|---|---|---|---|---|---|---|
| 0 | 0 | 0 | 0 | 0 | 0 | 0 | 0 | 0 |
| 1 | 1 | 11 | 13 | 23 | 25 | 3 | 5 | 15 |
| 2 | 2 | 22 | 26 | 14 | 18 | 6 | 10 | 30 |
| 3 | 3 | 1 | 7 | 5 | 11 | 9 | 15 | 13 |
| 4 | 4 | 12 | 20 | 28 | 4 | 12 | 20 | 28 |
| 5 | 5 | 23 | 1 | 19 | 29 | 15 | 25 | 11 |
| 6 | 6 | 2 | 14 | 10 | 22 | 18 | 30 | 26 |
| 7 | 7 | 13 | 27 | 1 | 15 | 21 | 3 | 9 |
| 8 | 8 | 24 | 8 | 24 | 8 | 24 | 8 | 24 |
| 9 | 9 | 3 | 21 | 15 | 1 | 27 | 13 | 7 |
| 10 | 10 | 14 | 2 | 6 | 26 | 30 | 18 | 22 |
| 11 | 11 | 25 | 15 | 29 | 19 | 1 | 23 | 5 |
| 12 | 12 | 4 | 28 | 20 | 12 | 4 | 28 | 20 |
| 13 | 13 | 15 | 9 | 11 | 5 | 7 | 1 | 3 |
| 14 | 14 | 26 | 22 | 2 | 30 | 10 | 6 | 18 |
| 15 | 15 | 5 | 3 | 25 | 23 | 13 | 11 | 1 |
| 16 | 16 | 16 | 16 | 16 | 16 | 16 | 16 | 16 |
| 17 | 17 | 27 | 29 | 7 | 9 | 19 | 21 | 31 |
| 18 | 18 | 6 | 10 | 30 | 2 | 22 | 26 | 14 |
| 19 | 19 | 17 | 23 | 21 | 27 | 25 | 31 | 29 |
| 20 | 20 | 28 | 4 | 12 | 20 | 28 | 4 | 12 |
| 21 | 21 | 7 | 17 | 3 | 13 | 31 | 9 | 27 |
| 22 | 22 | 18 | 30 | 26 | 6 | 2 | 14 | 10 |
| 23 | 23 | 29 | 11 | 17 | 31 | 5 | 19 | 25 |
| 24 | 24 | 8 | 24 | 8 | 24 | 8 | 24 | 8 |
| 25 | 25 | 19 | 5 | 31 | 17 | 11 | 29 | 23 |
| 26 | 26 | 30 | 18 | 22 | 10 | 14 | 2 | 6 |
| 27 | 27 | 9 | 31 | 13 | 3 | 17 | 7 | 21 |
| 28 | 28 | 20 | 12 | 4 | 28 | 20 | 12 | 4 |
| 29 | 29 | 31 | 25 | 27 | 21 | 23 | 17 | 19 |
| 30 | 30 | 10 | 6 | 18 | 14 | 26 | 22 | 2 |
| 31 | 31 | 21 | 19 | 9 | 7 | 29 | 27 | 17 |

FIG. 12 Reihenfolge (I) der Codewerte bei V=12; M=3
in Abhängigkeit von λ

| I \ λ | 11 | 7 | 5 | 1 | -1 | -5 | -7 | -11 |
|---|---|---|---|---|---|---|---|---|
| 0 | 0 | 0 | 0 | 0 | 0 | 0 | 0 | 0 |
| 1 | 1 | 29 | 31 | 23 | 25 | 17 | 19 | 11 |
| 2 | 2 | 22 | 26 | 10 | 14 | 34 | 2 | 22 |
| 3 | 3 | 15 | 21 | 33 | 3 | 15 | 21 | 33 |
| 4 | 4 | 8 | 16 | 20 | 28 | 32 | 4 | 8 |
| 5 | 5 | 1 | 11 | 7 | 17 | 13 | 23 | 19 |
| 6 | 6 | 30 | 6 | 30 | 6 | 30 | 6 | 30 |
| 7 | 7 | 23 | 1 | 17 | 31 | 11 | 25 | 5 |
| 8 | 8 | 16 | 32 | 4 | 20 | 28 | 8 | 16 |
| 9 | 9 | 9 | 27 | 27 | 9 | 9 | 27 | 27 |
| 10 | 10 | 2 | 22 | 14 | 34 | 26 | 10 | 2 |
| 11 | 11 | 31 | 17 | 1 | 23 | 7 | 29 | 13 |
| 12 | 12 | 24 | 12 | 24 | 12 | 24 | 12 | 24 |
| 13 | 13 | 17 | 7 | 11 | 1 | 5 | 31 | 35 |
| 14 | 14 | 10 | 2 | 34 | 26 | 22 | 14 | 10 |
| 15 | 15 | 3 | 33 | 21 | 15 | 3 | 33 | 21 |
| 16 | 16 | 32 | 28 | 8 | 4 | 20 | 16 | 32 |
| 17 | 17 | 25 | 23 | 31 | 29 | 1 | 35 | 7 |
| 18 | 18 | 18 | 18 | 18 | 18 | 18 | 18 | 18 |
| 19 | 19 | 11 | 13 | 5 | 7 | 35 | 1 | 29 |
| 20 | 20 | 4 | 8 | 28 | 32 | 16 | 20 | 4 |
| 21 | 21 | 33 | 3 | 15 | 21 | 33 | 3 | 15 |
| 22 | 22 | 26 | 34 | 2 | 10 | 14 | 22 | 26 |
| 23 | 23 | 19 | 29 | 25 | 35 | 31 | 5 | 1 |
| 24 | 24 | 12 | 24 | 12 | 24 | 12 | 24 | 12 |
| 25 | 25 | 5 | 19 | 35 | 13 | 29 | 7 | 23 |
| 26 | 26 | 34 | 14 | 22 | 2 | 10 | 26 | 34 |
| 27 | 27 | 27 | 9 | 9 | 27 | 27 | 9 | 9 |
| 28 | 28 | 20 | 4 | 32 | 16 | 8 | 28 | 20 |
| 29 | 29 | 13 | 35 | 19 | 5 | 25 | 11 | 31 |
| 30 | 30 | 6 | 30 | 6 | 30 | 6 | 30 | 6 |
| 31 | 31 | 35 | 25 | 29 | 19 | 23 | 13 | 17 |
| 32 | 32 | 28 | 20 | 16 | 8 | 4 | 32 | 28 |
| 33 | 33 | 21 | 15 | 3 | 33 | 21 | 15 | 3 |
| 34 | 34 | 14 | 10 | 26 | 22 | 2 | 34 | 14 |
| 35 | 35 | 7 | 5 | 13 | 11 | 19 | 17 | 25 |